Europäisches Patentamt

European Patent Office

Office européen des brevets

(19)

(11)  **EP 1 129 432 B1**

(12)  **FASCICULE DE BREVET EUROPEEN**

(45) Date de publication et mention
de la délivrance du brevet:
**06.11.2002  Bulletin 2002/45**

(51) Int Cl.⁷: **G06T 7/00**, G01R 31/307

(21) Numéro de dépôt: **99920907.5**

(22) Date de dépôt: **21.05.1999**

(86) Numéro de dépôt international:
**PCT/FR99/01211**

(87) Numéro de publication internationale:
**WO 00/030038 (25.05.2000 Gazette 2000/21)**

(54) **PROCEDE DE COMPARAISON D'IMAGES ENREGISTREES FORMEES DE PIXELS REPRESENTANT DES EQUIPOTENTIELLES D'AU MOINS UNE PUCE DE CIRCUIT INTEGRE**

VERFAHREN ZUM VERGLEICH VON AUS BILDPUNKTEN BESTEHENDEN GESPEICHERTEN BILDERN, DIE ÄQUIPOTENTIELEN MINDESTENS EINER INTEGRIERTEN SCHALTUNG DARSTELLEN

METHOD FOR COMPARING RECORDED PIXEL IMAGES REPRESENTING EQUIPOTENTIAL LINES OF AT LEAST AN INTEGRATED CIRCUIT CHIP

(84) Etats contractants désignés:
**DE FR GB IE IT**

(30) Priorité: **13.11.1998  FR 9814276**

(43) Date de publication de la demande:
**05.09.2001  Bulletin 2001/36**

(73) Titulaire: **CENTRE NATIONAL D'ETUDES SPATIALES
F-75039 Paris Cedex 01 (FR)**

(72) Inventeurs:
• **Desplats, Romain**
  **31400 Toulouse (FR)**
• **Perdu, Philippe**
  **31100 Toulouse (FR)**

(74) Mandataire:
**Cabinet BARRE LAFORGUE & associés
95, rue des Amidonniers
31000 Toulouse (FR)**

(56) Documents cités:
**EP-A- 0 619 551          EP-A- 0 853 243**

**Description**

L'invention concerne un procédé de comparaison de deux images, dites images de départ, enregistrées, formées de pixels, de même format rectangulaire, représentant sous forme contrastée monochrome, avec E+1 niveaux de contraste possibles (E étant un nombre entier positif par exemple égal à 255) des lignes équipotentielles d'au moins une puce de circuit intégré.

On sait qu'il est possible d'analyser les défauts des circuits intégrés en comparant des images représentant, sous forme contrastée monochrome, les potentiels des pistes d'une puce, alors que les bornes d'entrée du circuit intégré sont soumises à des vecteurs prédéterminés de signaux d'entrée (cf. par exemple "Failure Analysis by dynamic voltage contrast development of a semi-automatic system" N. GERAUD-LIVIA, G. PEREZ, A. CUQUEL, P. PERDU, ISTFA 1987, Los Angeles, pp 67-73 ; Thèse de M. P. PERDU "Etude de circuits intégrés par contraste de potentiel : analyse des phénomènes de charge induits dans la couche de passivation", Université Paul Sabatier, n° 1740, 1994, pp 1-50 et EP-A-853243).

Dans les méthodes décrites jusqu'à maintenant, la comparaison des images de départ suppose un traitement informatique des images (analyse automatique de brillance et de contraste ; moyenne simple par intégration ; lissage de l'image numérisée ; suppression de l'information topographique par différence, seuillage interactif en trois niveaux de gris par l'opérateur sur l'écran couleur (trinarisation), érosion...).

Ensuite, les images sont superposées et recalées manuellement ou à l'aide d'un ordinateur pour faire apparaître la localisation du défaut.

Néanmoins, compte tenu de la grande complexité des images des circuits intégrés modernes tels que les circuits CMOS ou BICMOS, de telles méthodes semi-automatiques laissant une grande part à l'intervention humaine, ne sont pas suffisamment performantes, notamment du point de vue de leur vitesse d'exécution, et de la précision de la représentation des équipotentielles.

En outre, il est nécessaire de réaliser des images pour de nombreux états électriques (classiquement de plusieurs centaines à plusieurs dizaines de milliers), et pour chaque état électrique, un très grand nombre d'images pour couvrir toute la surface d'une même puce (plusieurs centaines, voir plusieurs milliers). La comparaison par l'homme de chaque paire d'images entre un circuit défaillant et un circuit de référence est extrêmement longue et fastidieuse, même lorsque l'alignement des images est assisté par ordinateur, et n'est donc pas suffisamment efficace pour pouvoir être mise en oeuvre à l'échelle industrielle.

Il est à noter à ce titre que l'industrie de la fabrication des circuits intégrés impose maintenant de pouvoir analyser les circuits défaillants de façon extrêmement rapide et systématique.

L'invention vise donc à pallier les inconvénients suscités des méthodes antérieures.

L'invention vise ainsi à proposer un procédé de comparaison d'images qui peut être en grande partie automatisé et être effectué de façon extrêmement rapide de façon répétée sur une multitude d'images.

L'invention vise aussi à éviter l'analyse visuelle d'images superposées par un opérateur humain pour les comparer.

L'invention vise également à optimiser la vitesse de traitement des images lors de cette comparaison.

L'invention vise aussi à proposer un procédé permettant d'effectuer différentes comparaisons d'images, notamment pour la recherche d'équipotentielles communes et/ou d'équipotentielles de même forme et emplacement et d'états de potentiel différents, et/ou réunion des équipotentielles à l'exclusion des équipotentielles communes..., et ce de façon simple et rapide.

Pour ce faire, l'invention concerne un procédé de comparaison de deux images, dites images de départ, enregistrées, formées de pixels, de même format rectangulaire, représentant sous forme contrastée monochrome, avec E+1 niveaux de contraste possibles, des lignes équipotentielles d'au moins une puce de circuit intégré, caractérisé en ce que :

- on soumet chaque image de départ à un traitement de seuillage adaptatif à trois niveaux de contraste distincts, dits niveaux de contraste normaux, blanc, noir et gris, de préférence correspondant respectivement aux valeurs numériques E, 0, et à une valeur au moins sensiblement médiane entre 0 et E -notamment INT (E/2), INT étant la fonction partie entière- de façon à affecter à chaque pixel de l'image l'un de ces trois niveaux de contraste normaux,

- on forme ensuite une image, dite image résultat, à partir des images de départ ainsi traitées, en affectant à chaque pixel de l'image résultat un niveau de contraste normal choisi parmi les trois niveaux de contraste normaux blanc, noir, gris, et déterminé selon une règle logique de comparaison prédéterminée en fonction de la nature de la comparaison à effectuer, et selon les niveaux de contraste normaux affectés aux pixels correspondant de même emplacement des images de départ à l'issue du traitement de seuillage adaptatif.

Dans tout le texte, les niveaux de contraste normaux sont désignés par souci de simplicité blanc, gris et noir, mais il est entendu que ces qualificatifs ne désignent pas nécessairement strictement les couleurs pures correspondantes, mais au contraire englobent aussi le cas où les niveaux de contrastes seraient colorés d'une même couleur foncée remplaçant le noir et/ou d'une même couleur claire remplaçant le blanc. L'invention est en effet aussi bien applicable dans ce cas. Le plus généralement, les images monochromes telles que celles obtenues au microscope électronique, sont en pratique contrastées en noir et blanc. En outre, en pratique, il suffit de définir un niveau de contraste normal foncé par une valeur faible (égale ou non à 0), un niveau de contraste clair pour une valeur forte (égale ou non à E) et un niveau de contraste intermédiaire pour une valeur médiane.

Les images de départ sont formées de pixels, c'est-à-dire au format d'enregistrement généralement désigné "bitmap". De telles images peuvent être issues directement d'un système d'imagerie numérique, ou résulter d'une transformation numérique à partir d'une image d'origine de format d'enregistrement différent.

Avantageusement et selon l'invention, pour réaliser le traitement de seuillage adaptatif d'une image de départ comprenant b colonnes de pixels et c lignes de pixels :

- on définit à partir de l'image de départ une pluralité de rectangles Ri, j formés de blocs rectangulaires de d lignes de pixels et e colonnes de pixels, extraits de l'image de départ, d<c et e<b, les rectangles Ri, j étant définis pour représenter l'image de départ en lignes i de rectangles et en colonnes j de rectangles,
- on calcule, pour chaque rectangle Ri,j, la valeur du niveau de contraste minimum NGmin, la valeur du niveau de contraste maximum NGmax, la valeur du niveau de contraste moyen NGmoy, la valeur de l'écart-type des niveaux de contraste ETNG, des différents pixels du rectangle Rij,
- on calcule le nombre de niveaux de contraste normaux devant être affectés à chaque rectangle Ri, j,
- on détermine la valeur de chaque niveau de contraste normal de chaque rectangle Ri, j,
- on établit, pour chaque rectangle Ri,j, une loi de transformation du niveau de contraste réel de chaque pixel de l'image de départ en un niveau de contraste normal affecté à ce pixel. On affecte ensuite un niveau de contraste normal à chaque pixel de chaque rectangle selon cette loi, et on reconstruit l'image de départ.

Chaque rectangle Ri,j est formé d'un bloc de pixels contigus, c'est-à-dire d'une portion rectangulaire de l'image de départ.

L'écart type ETNG est la racine carrée de la variance. On peut aussi utiliser la variance elle-même, ce qui permet d'éviter une opération, ou toute autre formule d'écart-type particulière représentative de la valeur des écarts par rapport au niveau de contraste moyen.

Avantageusement et selon l'invention, on définit les rectangles Ri,j de façon que :

. toute paire de rectangles Ri,j ; Ri,j+1 qui se jouxtent sur une même ligne de rectangles se chevauchent sur la moitié de leur largeur, c'est-à-dire présentent un nombre de colonnes en commun de l'ordre de e/2,

. toute paire de rectangles Ri,j ; Ri+1,j qui se jouxtent sur une même colonne de rectangles se chevauchent sur la moitié de leur largeur, c'est-à-dire présentent un nombre de lignes en commun de l'ordre de d/2.

Ce chevauchement des rectangles permet notamment d'éviter les défauts d'analyse dus au traitement numérique dans les cas très particuliers, ou, si un tel défaut se produit, d'en corriger les effets. En outre, chaque pixel étant calculé plusieurs fois (comme appartenant à plusieurs rectangles différents (jusqu'à quatre si l'on exclut les frontières ou jusqu'à neuf si on les inclut)) la convergence numérique du procédé est assurée dans la quasi-totalité des cas.

Avantageusement et selon l'invention, on choisit d et e de telle sorte que si la taille minimum de chaque objet représenté par l'image de départ est un rectangle de g pixels de longueur et f pixels de largeur, f≤g, on ait :

$$10\leq e \leq 10\, f \text{ et } 10\leq d \leq 10\, g$$

Avantageusement et selon l'invention, on choisit d et e compris entre 20 et 60, notamment de l'ordre de 40 pour f et g compris entre 5 et 15, notamment de l'ordre de 10. Avantageusement et selon l'invention, on choisit d et e de telle sorte que d/e=c/b. Ainsi, la forme des rectangles Ri, j correspond à celle de l'image de départ. Par exemple, si l'image de départ est carrée, les rectangles Ri, j sont carrés.

Avantageusement et selon l'invention, pour calculer le nombre de niveaux de contraste normaux NNG dans chaque rectangle Ri,j:

- on calcule le nombre de pics principaux NP de la courbe histogramme des niveaux de contraste réels du rectangle Ri,j, chaque pic correspondant à un maximum de la courbe histogramme,
- on définit les conditions suivantes :

  . première condition : la courbe histogramme présente au moins trois pics,
  . deuxième condition : NGmoy≥S1 et (NGmax-NGmin)/NGmoy≥S2,
  . troisième condition : NGmax-NGmin≥S3 et ETNG≥S4,
  . quatrième condition : la courbe histogramme présente au moins deux pics,
  . cinquième condition : NGmax-NGmin≥S5 et ETNG≥S6,
       où S1, S2, S3, S4, S5 et S6 sont des valeurs seuil prédéterminées selon le type de circuit intégré représenté par les images de départ et les caractéristiques de l'installation d'imagerie utilisée pour réaliser ces images de départ,
  . sixième condition : la première condition et l'une au moins de la deuxième condition ou de la troisième condition sont satisfaites,
  . septième condition : la quatrième condition et la cinquième conditions sont satisfaites,

- on examine si la sixième condition est satisfaisante, et, si tel est le cas, on fixe et on enregistre le nombre de niveaux de contraste normaux NNG égal à trois ; si tel n'est pas le cas, on examine si la septième condition est satisfaite et, si tel est le cas, on fixe et on enregistre le nombre de niveaux de contraste normaux NNG égal à deux ; si tel n'est pas le cas, aucune de la sixième et de la septième condition n'étant satisfaite, on fixe et on enregistre le nombre de niveaux de contraste normaux NNG égal à un.

Les valeurs seuils S1, S2, S3, S4, S5, S6 peuvent être fixées expérimentalement selon la nature des circuits intégrés, et des images de départ correspondantes.

Avantageusement et selon l'invention, les circuits intégrés étant de type CMOS avec des règles de dessins comprises entre 0,7μ et 1,5μ, on choisit : S1 de l'ordre de 100 ; S2 de l'ordre de 1,3 ; S3 de l'ordre de 160 ; S4 de l'ordre de 47 ; S5 de l'ordre de 130 ; S6 de l'ordre de 60.

Une fois le nombre de niveaux de contraste normaux déterminé, il convient de déterminer la valeur de chacun d'entre eux et d'affecter l'un d'entre eux à chaque pixel.

Avantageusement et selon l'invention, lorsque le nombre de niveaux de contraste normaux NNG d'au moins un rectangle Ri,j de l'image de départ est égal à trois, pour affecter un niveau de contraste normal NCN à chaque pixel dont le niveau de contraste réel est NCR :

- on sépare les pics de la courbe histogramme du rectangle Ri,j par des frontières verticales passant par les points de minimum entre les pics,
- on calcule par intégration l'aire de chaque pic de la courbe histogramme du rectangle Ri,j, on sélectionne les trois grands pics présentant des aires de plus grandes valeurs, on choisit parmi ces trois grands pics, un pic, dit pic central disposé entre les deux autres, et qui est délimité par une frontière inférieure FI et une frontière supérieure FS sur l'échelle des niveaux de contraste,
- on affecte le niveau de contraste normal NCN égal à gris pour tout pixel dont le niveau de contraste réel NCR est compris entre la frontière inférieure FI et la frontière supérieure FS,
- on affecte le niveau de contraste normal NCN égal à noir pour tout pixel dont le niveau de contraste réel NCR est inférieur à la frontière inférieure FI,
- on affecte le niveau de contraste normal NCN égal à blanc pour tout pixel dont le niveau de contraste réel NCR est supérieur à la frontière supérieure FS.

En outre, pour chaque rectangle Ri',j' dont le nombre de niveaux de contraste normaux NNG est inférieur ou égal à 2, on détermine la valeur de ce(ces) niveau(x) de contraste normal(aux) NNG à partir d'un rectangle Ri,j comprenant trois niveaux de contraste normaux que l'on a préalablement affectés, en affectant de proche en proche les niveaux de contraste normaux des pixels communs au(x) rectangle(s) qui se chevauchent entre les rectangles Ri,j et Ri',j'.

Avantageusement et selon l'invention, lorsqu'aucun rectangle Ri, j n'a un nombre de niveaux de contraste normaux NNG égal à trois, on traite les rectangles Ri,j les uns après les autres, de proche en proche, en étapes successives, en comparant lors de chaque étape une zone, dite zone de départ, formée d'au moins un rectangle Ri,j ayant subi préalablement une telle étape, et un rectangle Ri,j présentant une zone de chevauchement commune avec la zone de départ.

Avantageusement et selon l'invention, lorsque le nombre de niveaux de contraste normaux de tous les rectangles Ri,j est égal à 1, on affecte le niveau de contraste normal gris à tous les pixels de l'image.

Par ailleurs, avantageusement et selon l'invention, après avoir affecté les niveau de contraste normaux à tous les pixels d'un rectangle Ri,j, on soumet ce rectangle Ri,j à un traitement de réduction comprenant un filtrage médian lors duquel on affecte à chaque pixel la valeur médiane des niveaux de contraste normaux de l'ensemble de pixels comprenant ce pixel et les pixels qui l'entourent.

Avantageusement et selon l'invention, on reconstruit l'image de départ en réassemblant les rectangles Ri,j, les uns après les autres en étapes de réassemblage successives à partir d'une image grise de même format que l'image de départ, et en effectuant, pixel par pixel, une règle logique OU étendu OR+ entre l'image de l'étape précédente et le rectangle Ri,j à réassembler, en affectant à chaque pixel de l'image de départ à reconstruire le niveau de contraste normal :

- blanc si les pixels de l'image de l'étape de réassemblage précédente et du rectangle Ri,j sont, respectivement, blanc et gris ; ou blanc et blanc;
- noir si les pixels de l'image de l'étape de réassemblage précédente et du rectangle Ri,j sont, respectivement, noir et gris ; ou noir et noir ;
- gris dans les autres cas.

Cette reconstruction par OU étendu OR+ successifs permet de résoudre les éventuelles discordances de valeurs induites par le traitement de filtrage médian sur les rectangles.

Les règles logiques de comparaison pouvant être ensuite utilisées dans un procédé selon l'invention sont variées. Avantageusement et selon l'invention, on utilise une règle logique de comparaison choisie parmi les règles logiques de comparaison suivantes :

- intersection étendue AND+ : on affecte à chaque pixel de l'image résultat le niveau de contraste normal :

    . noir si les deux pixels correspondant des images de départ sont noirs,
    . blanc si les deux pixels correspondant des images de départ sont blancs,
    . gris dans les autres cas,

- OU EXCLUSIF étendu XOR+ : on affecte à chaque pixel de l'image résultat le niveau de contraste normal :

    . gris si les deux pixels correspondant des images de départ ont le même niveau de contraste normal,
    . blanc si les deux pixels correspondant des images de départ sont blanc et gris ; ou blanc et noir ; ou gris et noir,
    . noir si les deux pixels correspondant des images de départ sont noir et gris : ou noir et blanc ; ou gris et blanc. Il est à noter que l'ordre des images de départ a une importance pour la règle de comparaison ou exclusif étendu XOR+.

Si l'on souhaite comparer les différences entre les images (équipotentielles de même forme et emplacement et de potentiels différents), on peut utiliser une règle logique de comparaison semblable aux précédentes. Néanmoins, on peut aussi effectuer une différence entre des images pixelisées complexes (avec les niveaux de contraste réels) de façon numérique simple.

Ainsi, avantageusement et selon l'invention, au moins l'une des images de départ résulte d'une étape de différence effectuée préalablement entre deux images, dites images initiales, représentant une portion de surface d'une puce de circuit intégré, et lors de laquelle on calcule le niveau de contraste réel NCR de chaque pixel de l'image de départ à partir des niveaux de contraste réels NCRA et NCRB des pixels correspondant de même emplacement des images initiales selon la formule : NCR=(NCRA-NCRB)/2+INT(E/2). INT représente la fonction partie entière.

En outre, avant d'utiliser une image de départ dans une étape de comparaison d'images, on réalise préalablement une intégration de cette image de départ sur plusieurs clichés identiques correspondant à cette image de départ, et un filtrage médian en affectant à chaque pixel la valeur médiane de l'ensemble de pixels formé de ce pixel et des pixels qui l'entourent, de façon à supprimer les pics dus au bruit.

Avantageusement et selon l'invention, on réalise l'intégration et le filtrage médian sur les images initiales dont on fait ensuite la différence pour obtenir une image de départ.

Egalement, avantageusement et selon l'invention, on soumet l'image résultat à un traitement de réduction comprenant un filtrage médian consistant à affecter à chaque pixel la valeur médiane des niveaux de contraste normaux de l'ensemble de pixels comprenant ce pixel et les pixels qui l'entourent, puis un traitement d'érosion et de dilatation pour les niveaux de contraste normaux blanc et noir.

L'invention concerne aussi un procédé caractérisé en combinaison par tout ou partie des caractéristiques mentionnées ci-dessus ou ci-après.

L'invention fournit un procédé de comparaison extrêmement rapide et puissant, qui s'avère en pratique efficace pour comparer des images de circuits intégrés, notamment telles que celles issus des systèmes d'imagerie par microscopie électronique en contraste de potentiel par détection des électrons secondaires. Elle permet ainsi d'accélérer et de fiabiliser les méthodes d'analyse des défauts des circuits intégrés (localisation et caractérisation physique).

D'autres buts, caractéristiques et avantages de l'invention apparaîtront de la description suivante qui se réfère aux figures annexées données à titre d'exemple non limitatif et dans lesquelles :

- la figure 1 est un schéma donnant un exemple simplifié d'images traitées et comparées selon l'invention,
- la figure 2 est une vue schématique partielle d'une image de départ illustrant la définition des rectangles Ri,j,
- la figure 3 est un exemple d'histogramme d'un rectangle Ri,j selon l'invention,
- la figure 4 est un organigramme d'une étape d'un procédé selon l'invention permettant de déterminer le nombre de niveaux de contraste normaux NNG d'un rectangle Ri,j,
- les figures 5a et 5b sont des schémas illustrant une étape de traitement de réduction d'un procédé selon l'invention, dans le cas (figure 5a) d'une image à 256 niveaux de contraste réels, et dans le cas, (figure 5b), d'une image à trois niveaux de contraste normaux figure 5b obtenue après seuillage adaptatif.

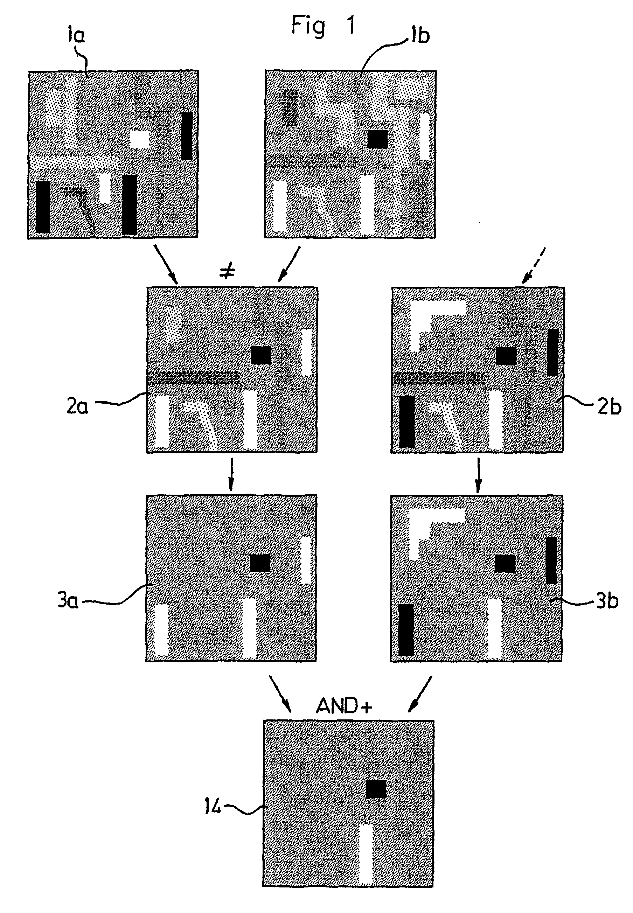

Sur la figure 1, on a représenté des images formées de pixels, de même format carré, représentant sous forme contrastée monochrome des lignes équipotentielles d'au moins une puce de circuit intégré, et ce sous forme extrêmement simplifiée, aux fins d'illustration de l'invention. En effet, dans la pratique, de telles images sont beaucoup plus complexes et représentent un nombre de détails beaucoup plus important. En outre, on n'a représenté qu'un faible nombre de niveaux de contraste réels (niveaux de gris), alors qu'en pratique ce nombre peut être très important, et est classiquement de 256 = E+1.

Les deux images 1a, 1b sont des images initiales représentant une portion de surface d'une puce de circuit intégré, obtenue par un système d'imagerie approprié qui peut être un système d'imagerie par microscopie électronique en contraste de potentiel par détection des électrons secondaires, par exemple un système IDS 5000 HX tel que commercialisé par la Société SCHLUMBERGER TECHNOLOGIES (FRANCE). Tout autre système d'imagerie peut aussi être utilisé, dès lors que les images obtenues représentent sous forme contrastée monochrome des lignes équipotentielles d'une puce de circuit intégré. Les images fournies par ces systèmes d'imagerie sont des images numérisées pixelisées présentant une échelle de niveaux de contraste comprenant par exemple et en général 256 niveaux de gris numérotés 0 à 255=E.

On réalise tout d'abord sur chacune des images initiales 1a, 1b, une intégration sur plusieurs clichés identiques correspondant à cette image initiale. Cette intégration consiste à réaliser n images identiques de la puce du circuit intégré successivement, et à affecter à chaque pixel 1a valeur moyenne du pixel des n images identiques. Par exemple, on choisit n=16.

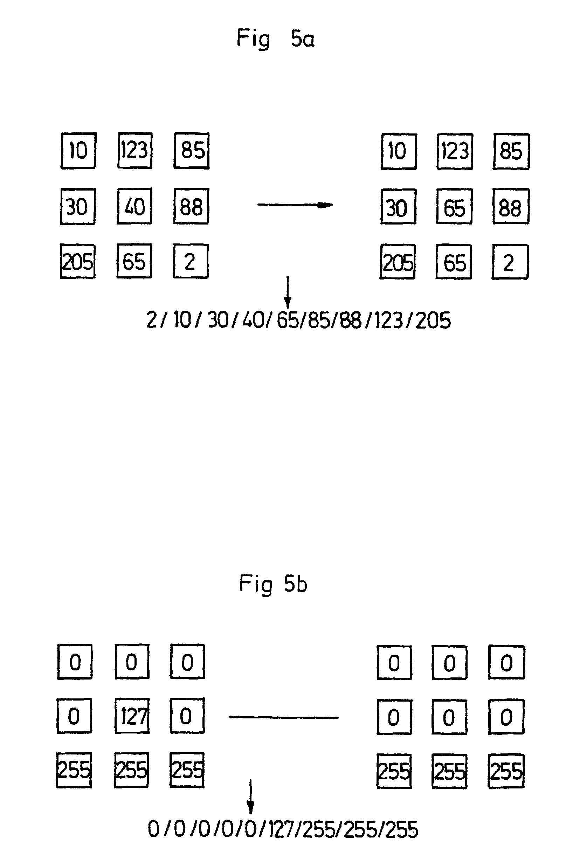

On effectue ensuite un filtrage médian en affectant à chaque pixel la valeur médiane de l'ensemble des pixels formé de ce pixel, et des pixels qui l'entourent, de façon à supprimer les pics dus au bruit. Ce filtrage médian est effectué comme représenté figure Sa. On considère le bloc de pixels formé d'un pixel et des huit pixels qui l'entourent. Dans l'exemple représenté, le pixel central a la valeur 40. On classe cet ensemble de pixels par valeur croissante et on choisit, pour modifier la valeur du pixel central, la valeur médiane obtenue par ce classement, c'est-à-dire la cinquième valeur qui, dans l'exemple représenté, est 65. On remplace ensuite la valeur du pixel central par cette valeur médiane 65 comme représenté sur la partie droite de la figure 5a. Pour les pixels des bordures, on duplique la colonne ou la ligne contenant le pixel pour former un ensemble de 9 pixels sur lequel on détermine la valeur médiane.

Le traitement d'intégration des images initiales 1a, 1b permet de réduire le bruit ergodique et stationnaire. Le filtrage médian permet de supprimer les pics de bruit sans affecter la dynamique et le contraste des images. Ces opérations sont effectuées par voie numérique, pixel par pixel.

A partir des deux images initiales 1a, 1b, on réalise une différence numérique permettant d'obtenir une image de départ 2a. Pour effectuer cette différence, on calcule le niveau de contraste réel NCR de chaque pixel de l'image de départ 2a à partir des niveaux de contraste réel NCRA et NCRB des pixels correspondant de même emplacement des images initiales 1a, 1b, selon la formule : NCR=(NCRA-NCRB)/2+INT(E/2), où INT représente la fonction partie entière.

Cette formule de différence part de l'hypothèse selon laquelle les niveaux de contraste réels des équipotentielles d'une puce de circuit intégré sont soit situés dans le blanc, soit situés dans le noir, selon l'état logique de la ligne équipotentielle (le signal qui la traverse étant à basse tension ou à haute tension), le fond de l'image étant représenté par du gris. En conséquence, pour les pixels présentant des niveaux de contraste réels semblables ou proches (c'est-à-dire des potentiels voisins), l'image résultant de la différence présente un pixel situé dans les gris. A l'inverse, si les niveaux de contraste réels d'un pixel entre les deux images initiales 1a, 1b, sont très différents, le pixel de l'image résultat apparaîtra dans les blancs ou les noirs.

On obtient ainsi une image de départ 2a présentant E+1 (par exemple 256) niveaux de contraste possibles. De façon semblable, on peut obtenir une deuxième image 2b ayant E+1 niveaux de contraste possibles. Cette deuxième image de départ 2b est ou non le résultat d'un traitement numérique de différence de deux autres images initiales.

Le procédé selon l'invention permet de comparer les deux images de départ 2a, 2b. Pour ce faire, on soumet tout d'abord chacune de ces images de départ 2a, 2b a un traitement de seuillage adaptatif à trois niveaux de contraste, dits niveaux de contraste normaux, blancs, noir et gris, correspondant respectivement aux valeurs numériques E,0 et une valeur médiane entre 0 et E -notamment INT(E/2) ou INT (E/2)+1-, de façon à affecter à chaque pixel de l'image ainsi traitée, l'un de ces trois niveaux de contraste normaux. On obtient ainsi une image 3a, 3b qui ne présente plus que trois niveaux de contraste normaux. Avec E = 255, les pixels noirs ont la valeur 0, les blancs ont la valeur 255 et les gris ont la valeur 127. D'autres valeurs peuvent être choisies, dès lors que trois niveaux de contraste normaux distincts équilibrés, un faible (foncé), un fort (clair) et un intermédiaire, sont définis.

Il est à noter que l'étape de traitement numérique de différence effectuée préalablement permet non seulement de mettre en évidence les états électriques distincts entre les deux images initiales 1a, 1b, mais également divise le bruit par deux, diminue l'effet de la topographie, et diminue la quantité d'informations à traiter ultérieurement, notamment lors de l'étape de seuillage adaptatif.

L'étape de seuillage adaptatif est effectuée comme décrit ci-après.

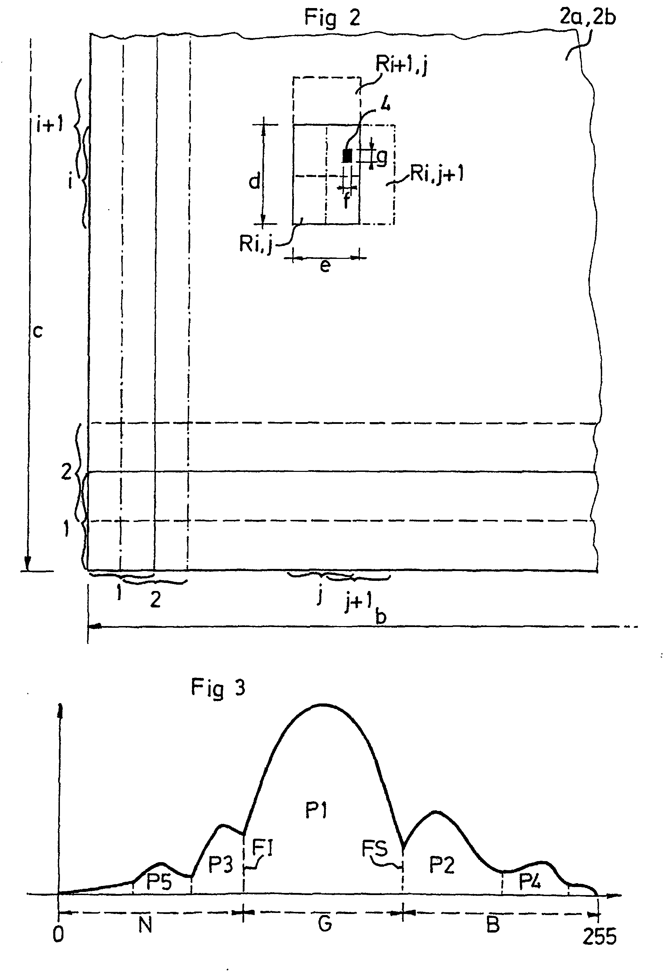

L'image de départ 2a, 2b comprend b colonnes de pixel et c lignes de pixel. Comme représenté figure 2, on définit à partir de l'image de départ 2a, 2b, une pluralité de rectangles Ri,j. Chaque rectangle Ri,j est formé d'un bloc rectangulaire ayant d lignes de pixel et e colonnes de pixel, et est extrait de l'image de départ 2a, 2b. Les rectangles Ri,j sont définis pour représenter l'image de départ 2a, 2b en lignes numérotées i de rectangles et en colonnes numérotées j de rectangles. Les rectangles sont plus petits que le format total de l'image de départ, c'est-à-dire que d<c et e<b. Comme on le voit figure 2, on définit les rectangles Rij de façon que pour tout i et j:

.   deux rectangles Ri,j ; Ri,j+1 qui se jouxtent sur une même ligne i de rectangles se chevauchent sur la moitié de leur largeur, c'est-à-dire présentent un nombre de colonnes en commun de l'ordre de e/2,

. deux rectangles Ri,j ; Ri+1,j qui se jouxtent sur une même colonne j de rectangles se chevauchent sur la moitié de leur largeur, c'est-à-dire présentent un nombre de lignes en commun de l'ordre de d/2.

Ainsi, chaque pixel appartient en général à plusieurs rectangles distincts Ri,j ; Ri+1,j ; Ri,j+1 ; et Ri+1,j+1 (jusqu'à quatre si l'on ne tient pas compte des frontières, ou jusqu'à neuf si l'on en tient compte).

La dimension d et e d'un rectangle est choisie par rapport à la taille minimum de chaque objet représenté par l'image de départ 2a, 2b. Cette taille minimum d'objet est représentée par un rectangle de g pixels de longueur et f pixels de largeur, f≤g. On choisit d et e de telle sorte que : 10≤ e ≤10 f, 10≤ d ≤10 g.

Avantageusement, on choisit d et e compris entre 20 et 60, notamment de l'ordre de 40 pour f et g compris entre 5 et 15, notamment de l'ordre de 10. On a représenté figure 2 un objet noir 4 de taille minimum souhaitée. On connaît en effet aisément la taille minimum des objets des images compte tenu du fait que ces images représentent des circuits intégrés dont la largeur des pistes est connue.

En outre, on choisit d et e de telle sorte que d/e=c/b, c'est-à-dire de telle sorte que la forme des rectangles corresponde à celle de l'image de départ 2a, 2b. On évite ainsi tout phénomène d'amplification dans une direction du traitement de seuillage adaptatif.

Dans chaque rectangle Ri,j :

- on calcule pour chaque rectangle Ri,j les valeurs du niveau de contraste minimum NGmin, du niveau de contraste maximum NGmax, du niveau de contraste moyen NGmoy, de l'écart-type des niveaux de contraste ETNG, des différents pixels du rectangle Rij,

- on calcule le nombre de niveaux de contraste normaux devant être affectés à chaque rectangle Ri,j,

- on détermine la valeur de chaque niveau de contraste normal de chaque rectangle Ri,j,

- on établit, pour chaque rectangle Ri,j, une loi de transformation des niveaux de contraste réels de chaque pixel de l'image de départ en un niveau de contraste normal affecté à ce pixel, comme indiqué ci-après, et on affecte leur niveau de contraste normal à chaque pixel selon cette loi.

Dans chaque rectangle Ri,j, on connaît la valeur de chaque pixel, et l'on peut tracer la courbe histogramme des niveaux de contraste réels (figure 3). Un tel histogramme représente en abscisses les niveaux de contraste réels de 0 à E=255, et, en ordonnées, le nombre de pixels du rectangle pour chaque niveau de contraste réel.

On calcule le nombre de pics principaux NP de cette courbe correspondant chacun à un maximum, et ce par voie numérique de la manière suivante :

- on effectue un lissage numérique en remplaçant la valeur de chaque pixel par la valeur moyenne calculée sur cinq pixels avoisinants,

- on réalise une extrapolation polynomiale de la courbe de l'histogramme lissée, et on calcule et on enregistre la fonction dérivée du polynôme,

- on calcule, on enregistre et on ordonne les racines de cette dérivée par ordre croissant,

- on enregistre les racines alternativement et successivement en tant que valeurs de maximum et valeurs de minimum, la première racine étant une valeur de maximum.

Pour calculer le nombre de niveaux de contraste normaux NNG dans chaque rectangle Ri,j, on définit les conditions suivantes :

. première condition : la courbe histogramme présente au moins trois pics (NP ≥ 3),

. deuxième condition : NGmoy≥S1 et (NGmax-NGmin)/NGmoy≥S2,

. troisième condition : NGmax-NGmin≥S3 et ETNG≥S4,

. quatrième condition : la courbe histogramme présente au moins deux pics (NP ≥ 2),

. cinquième condition : NGmax-NGmin≥S5 et ETNG≥S6,

    où S1, S2, S3, S4, S5 et S6 sont des valeurs seuil prédéterminées selon le type de circuit intégré représenté par les images de départ et les caractéristiques de l'installation d'imagerie utilisée pour réaliser ces images de départ,

. sixième condition : la première condition et l'une au moins de la deuxième condition ou de la troisième condition sont satisfaites,

. septième condition : la quatrième condition et la cinquième conditions sont satisfaites,

- on examine si la sixième condition est satisfaite, et, si tel est le cas, on fixe et on enregistre le nombre de niveaux de contraste normaux NNG égal à trois ; si tel n'est pas le cas, on examine si la septième condition est satisfaite et, si tel est le cas, on fixe et on enregistre le nombre de niveaux de contraste normaux NNG égal à deux ; si tel n'est pas le cas, aucune de la sixième et de la septième condition n'étant satisfaite, on fixe et on enregistre le nombre de niveaux de contraste normaux NNG égal à un.

Les valeurs seuil S1, S2, S3, S4, S5, S6 peuvent être prédéterminées expérimentalement à partir d'images connues en examinant les différentes conditions dans les différentes zones des images, où l'on sait, par examen visuel, que ces zones devraient contenir trois niveaux de contraste normaux, ou deux, ou un seul.

Il suffit de tracer un tableau représentant les différentes valeurs statistiques susmentionnées pour les différentes zones de l'image visualisée. On peut alors définir des frontières séparant les niveaux de contraste normaux sur l'image. En pratique, cette opération expérimentale est rapide et peut être effectuée à partir d'une ou deux images. Elle reste valable pour chaque circuit intégré de même technologie et pour chaque dispositif d'imagerie.

Par exemple, avec le système d'imagerie IDS 5000 HX et pour des circuits intégrés de type CMOS, avec des règles de dessins comprises entre $0,7\mu$ et $1,5\mu$, on choisit : S1 de l'ordre de 100 ; S2 de l'ordre de 1,3 ; S3 de l'ordre de 160 ; S4 de l'ordre de 47 ; S5 de l'ordre de 130 ; S6 de l'ordre de 60.

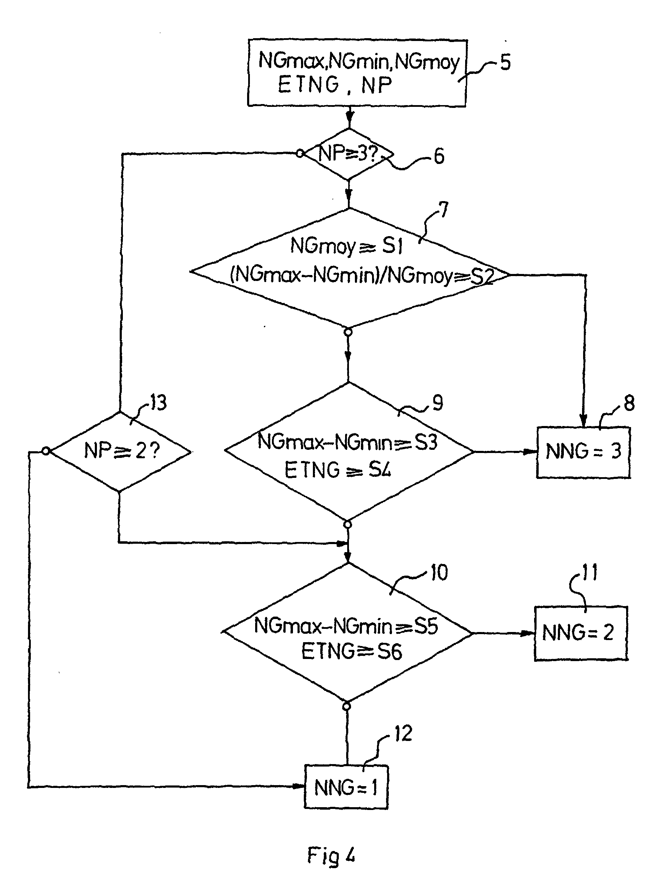

La figure 4 représente l'organigramme de l'étape mentionnée ci-dessus permettant de déterminer la valeur du nombre de niveaux de gris normaux NNG du rectangle Ri,j. L'étape 5 représente le calcul des variables statistiques NGMax, NGmin, NGmoy, ETNG, et NP. On examine lors de l'étape 6 si $NP \geq 3$. Si tel est le cas, on examine si la deuxième condition est satisfaite lors de l'étape 7. si cette condition est satisfaite, NNG=3 (étape 8). Dans le cas contraire, on examine si la troisième condition est satisfaite lors de l'étape 9. Si tel est le cas, on fixe NNG=3. Dans le cas contraire, on examine la cinquième condition lors de l'étape 10. Si tel est le cas, on fixe NNG=2 lors de l'étape 11. Dans le cas contraire, on fixe NNG=1 lors de l'étape 12. Si NP n'est pas égal à 3 lors de l'étape 6, on examine s'il est supérieur ou égal à 2 lors de l'étape 13. Si tel est le cas, on reprend le procédé à l'étape 10 (examen de la cinquième condition). Dans le cas contraire, on fixe NNG=1 lors de l'étape 12.

Il est à noter qu'on peut, en variante non représentée, utiliser l'une seulement des étapes 7 ou 9, c'est-à-dire l'une seulement de la deuxième condition ou de la troisième condition.

Il convient ensuite d'attribuer un niveau de contraste normal à chaque pixel de l'image. Pour ce faire, plusieurs situations peuvent se présenter.

Lorsque le nombre de niveaux de contraste normaux NNG d'au moins un rectangle Ri,j de l'image de départ est égal à trois, pour affecter à chaque pixel de niveau de contraste réel NCR, un niveau de contraste normal NCN:

- on sépare les pics de la courbe histogramme du rectangle Ri,j par des frontières verticales passant par les points de minimum entre les pics,
- on calcule par intégration et on enregistre l'aire de chaque pic de la courbe histogramme du rectangle Ri,j, on sélectionne les trois grands pics présentant des aires de plus grandes valeurs, on choisit parmi ces trois grands pics, un pic, dit pic central disposé entre les deux autres, et qui est délimité par une frontière inférieure FI et une frontière supérieure FS sur l'échelle des niveaux de contraste,

- on affecte et on enregistre le niveau de contraste normal NCN égal à gris pour tout pixel dont le niveau de contraste réel NCR est compris entre la frontière inférieure FI et la frontière supérieure FS,
- on affecte et on enregistre le niveau de contraste normal NCN égal à noir pour tout pixel dont le niveau de contraste réel NCR est inférieur à la frontière inférieure FI,
- on affecte et on enregistre le niveau de contraste normal NCN égal à blanc pour tout pixel dont le niveau de contraste réel NCR est supérieur à la frontière supérieure FS.

Ensuite, pour chaque rectangle Ri',j' dont le nombre de niveaux de contraste normaux NNG est inférieur ou égal à 2, on détermine la valeur de ce(ces) niveau(x) de contraste normal(aux) NNG à partir d'un rectangle Ri,j comprenant trois niveaux de contraste normaux que l'on a préalablement affectés, en affectant de proche en proche les niveaux de contraste normaux des pixels communs au(x) rectangle(s) qui se chevauchent entre les rectangles Ri,j et Ri',j'.

Dès lors, on voit que si l'un au moins des rectangles Ri,j présente un nombre de niveaux de contraste normaux NNG=3, l'ensemble de l'image de départ de 2a, 2b peut être traité par seuillage adaptatif, la valeur de chaque pixel pouvant être affectée à un niveau de contraste normal.

Lorsque aucun rectangle Ri, j n'a un nombre de niveaux de contraste normaux NNG égal à trois, mais qu'au moins un rectangle Ri,j a un nombre de niveaux de contraste normal égal à deux, à savoir un niveau de contraste normal inférieur et un niveau de contraste normal supérieur, on affecte le niveau de contraste normal gris à l'un des niveaux de contraste normaux d'au moins un rectangle, dit premier rectangle, ayant deux niveaux de contraste normaux, et on affecte les niveaux de contraste normaux des autres rectangles de proche en proche à partir du premier rectangle.

On sait en effet que le niveau de contraste le plus fréquemment représenté dans une image est le gris (figure 3), correspondant au fond de l'image, les lignes équipotentielles apparaissant en général en blanc ou en noir. En conséquence, on peut normalement trouver sur l'image au moins un premier rectangle ayant deux niveaux de contraste normaux, et pour lequel l'un d'entre eux peut être affecté au gris. Cette affectation peut être effectuée par examen manuel et saisie manuelle, c'est-à-dire par intervention de l'opérateur humain. Dès que le niveau de contraste normal gris du premier rectangle est affecté, tous les pixels de l'image peuvent être calculés par voie numérique. En effet, le deuxième niveau de contraste normal du premier rectangle est affecté en examinant si le pic correspondant est au-dessus ou en dessous, sur l'histogramme, du niveau de contraste normal gris préalablement affecté. Ensuite, on affecte les niveaux de contraste des autres rectangles de proche en proche à partir du premier rectangle.

Lorsqu'aucun rectangle Ri,j n'a un nombre de niveaux de contraste normaux NNG égal à trois, on peut automatiser par calcul numérique la détermination de la valeur (blanc, noir ou gris) du (des) niveau(x) de contraste normal(aux) de chaque rectangle Ri,j par voie numérique de la façon suivante.

On traite les rectangles Ri,j les uns après les autres, de proche en proche, en étapes successives. Lors de chaque étape, on compare une zone, dite zone de départ, formée d'au moins un rectangle Ri,j ayant subi préalablement une telle étape, et un rectangle Ri,j présentant une zone de chevauchement commune avec la zone de départ.

Si la zone de départ présente un et un seul niveau de contraste normal NGa et le rectangle présente un et un seul niveau de contraste normal NGb, alors NGa=NGb. On réunit le rectangle et la zone de départ pour former la zone de départ subséquente qui aura aussi un et un seul niveau de contraste normal et on passe au rectangle suivant.

Si la zone de départ présente un et un seul niveau de contraste normal NGa et le rectangle présente deux niveaux de contraste normaux NGc et NGd, NGc>NGd (NGc est blanc ou gris et NGd est noir ou gris), on sait que NGa=NGc ou NGa=NGd. On réunit le rectangle et la zone de départ pour former la zone de départ subséquente dont on sait qu'elle présentera deux niveaux de contraste normaux renommés NGa et NGb, et on passe au rectangle suivant.

Si la zone de départ présente deux niveaux de contraste normaux NGa>NGb (NGa est blanc ou gris, et NGb est noir ou gris) et le rectangle présente un et un seul niveau de contraste normal NGc, on sait que NGa=NGc ou NGb=NGc. On réunit le rectangle et la zone de départ subséquente, dont on sait qu'elle présentera les deux niveaux de contraste normaux NGa et NGb, et on passe au rectangle suivant.

Si la zone de départ présente deux niveaux de contraste normaux NGa>NGb et le rectangle présente deux niveaux de contraste normaux NGc>NGd, on examine préalablement la zone de chevauchement commune entre la zone de départ et le rectangle. Pour ce faire, on prend une hypothèse d'essai, par exemple NGa=NGc=blanc et NGb=NGd=noir. Si R' est la portion de la zone de départ correspondant à cette zone de chevauchement et R" est la partie du rectangle correspondant à cette zone de chevauchement, on affecte les niveaux de contraste normaux NGa=NGc ou NGb=NGd aux pixels de R' et R", et on réalise l'opération logique R' XOR+ R", pixel par pixel, puis un filtrage médian du résultat de cette opération logique.

L'opération XOR+ est un OU exclusif étendu, tel que défini ci-après, qui permet de savoir si certains pixels présentent un niveau de contraste normal différent dans R' et R".

Si le résultat est entièrement gris, il n'y a pas de pixels ayant un niveau de contraste normal différent dans R' et R". Il suffit alors d'examiner les pixels de R', par exemple en comparant les valeurs minimales et maximales des pixels pour savoir si l'on est réellement dans l'un ou l'autre des cas suivants : NGa=NGc (un niveau haut) ; ou NGb=NGd (un niveau bas) ; ou, s'il y a deux niveaux distincts, NGa=NGc et NGb=NGd, soit (NGa,NGb)=(NGc,NGd).

Si le résultat de l'opération XOR+ n'est pas entièrement gris, on sait qu'il n'y a qu'un seul niveau de contraste dans R' et R", NGa ou NGb. On sait en outre si ce niveau de contraste normal est haut ou bas. S'il est haut, on a NGa=NGd, s'il est bas, on a NGb=NGc.

Selon ces résultats de l'examen préalable de la zone de chevauchement, on peut poursuivre de la façon suivante.

Si (NGa,NGb)=(NGc,NGd), on réunit le rectangle et la zone de départ pour former la zone de départ subséquente dont on sait qu'elle présentera deux niveaux de contraste normaux NGa et NGb.

Si NGb=NGd, on ne peut rien savoir sur NGa et NGc. On enregistre la zone de départ, on limite la nouvelle zone de départ subséquente au rectangle qui vient d'être traité, et on passe au rectangle suivant.

Si l'on arrive ainsi au dernier rectangle à traiter sans que les niveaux de contraste normaux ne soient affectés (on ne sait toujours pas si l'image de départ totale comprend deux ou trois niveaux de contraste normaux), on choisit la zone de départ enregistrée dont l'aire est la plus grande (ayant le plus grand nombre de pixels), et on affecte le pic principal de l'histogramme de cette zone au gris. A partir de cette valeur, on peut déterminer ensuite l'autre niveau de contraste normal de cette zone. On itère, le cas échéant, cette affectation sur toutes les autres zones de départ enregistrées.

Si NGa=NGc, on ne peut rien savoir sur NGb et NGd, et on procède comme indiqué pour le cas NGb=NGd.

Si NGb=NGc, alors NGa>NGb=NGc>NGd. On a alors trois niveaux de contraste normaux dans l'image : NGa=blanc, NGb=NGc=gris, et NGd=noir. Les niveaux de contraste normaux de chaque pixel peuvent alors être affectés à partir de cette zone de départ et de ce rectangle.

De même, si NGa=NGd, alors NGc=blanc>NGd=NGa=gris>NGb=noir.

Le niveau de contraste normal de chacun des pixels peut alors être affecté à partir de cette zone de départ et de ce rectangle.

Malgré le traitement ci-dessus, il peut arriver en pratique dans des cas très improbables et très rares que les niveaux de contraste normaux ne puissent pas être affectés dans des zones très particulières de l'image. On procède alors pour ces zones à l'affectation visuelle et manuelle des niveaux de contraste normaux.

Par ailleurs, on affecte le niveau de contraste normal de chaque pixel à partir de l'histogramme du rectangle, comme indiqué précédemment (dans le cas de trois niveaux de contraste normaux), en séparant les pics principaux par des frontières verticales et en examinant où se situe la valeur du niveau de contraste réel du pixel par rapport aux frontières.

En outre, lorsque le nombre de niveaux de contraste normaux de tous les rectangles Ri,j est égal à 1, on affecte le niveau de contraste normal gris à tous les pixels de l'image. En effet, on sait que le gris correspondant au fond de l'image est le niveau de contraste majoritaire.

Ainsi, chaque pixel des images 3a, 3b peut être calculé par seuillage adaptatif à partir des images 2a, 2b.

Après avoir affecté les niveau de contraste normaux à tous les pixels d'un rectangle Ri,j, on soumet ce rectangle Ri,j à un traitement de réduction comprenant un filtrage médian lors duquel on affecte à chaque pixel la valeur médiane des niveaux de contraste normaux de l'ensemble de pixels comprenant ce pixel et les pixels qui l'entourent.

Le traitement de réduction comprend en outre avantageusement une érosion et une dilatation des pixels pour les niveaux de contraste normaux noir et blanc. Ce traitement d'érosion ou de dilatation de pixels, bien connu en lui-même, permet de supprimer les pixels en saillie ou en creux non significatifs. Avec un tel traitement, un pixel isolé est supprimé, un pixel en saillie par rapport à un bloc de mêmes niveaux de contraste est supprimé, et un pixel en creux dans un bloc de niveaux de contraste différents est replacé au niveau de contraste du bloc. Les groupes de pixels sont donc reformés en blocs polygonaux.

La figure 5b représente le traitement de filtrage médian effectué sur une portion d'image ayant subi un seuillage adaptatif à trois niveaux de contraste. Comme on le voit, dans chaque ensemble de pixels, on choisit la valeur de niveaux de contraste normal correspondant à la cinquième valeur obtenue en classant les neufs valeurs dans l'ordre croissant.

Les images de départ 3a, 3b sont ensuite reconstruites à partir d'une image de même format entièrement grise dans laquelle on réassemble les rectangles Ri,j les uns après les autres en étapes de réassemblage successives.

A chaque étape de réassemblage, on traite un rectangle Ri,j pour le réassembler à l'image, et on effectue pixel par pixel une opération logique OU étendu OR+ entre l'image obtenue à l'étape de réassemblage précédente (image grise s'il s'agit de la première étape de réassemblage) et le rectangle Ri,j, en affectant à chaque pixel de l'image de départ 3a, 3b à reconstruire le niveau de contraste normal suivant :

- blanc si les pixels de l'image de l'étape de réassemblage précédente et du rectangle Ri,j sont, respectivement, blanc et gris ; ou blanc et blanc ;
- noir si les pixels de l'image de l'étape de réassemblage précédente et du rectangle Ri,j sont, respectivement, noir et gris ; ou noir et noir ;
- gris dans les autres cas.

On réalise ainsi une dilatation qui permet de corriger les éventuelles incohérences introduites par le traitement de filtrage médian précédent. Ainsi, si un même pixel est affecté au gris dans un rectangle et à un niveau de contraste normal extrême (noir ou blanc) dans un autre, on lui affectera, par l'opération OR+ ce niveau de contraste normal extrême dans l'image de départ 3a, 3b. Si ce pixel est noir dans un rectangle et blanc dans un autre, il s'agit probablement d'une zone frontière entre deux équipotentielles de niveaux de potentiel opposés, et il est alors affecté au gris, ce qui matérialisera la frontière.

Après avoir effectué l'étape de seuillage adaptatif, on peut utiliser les images 3a, 3b ainsi traitées présentant trois niveaux de contraste normaux seulement pour effectuer des règles logiques de comparaison. Selon l'invention, on forme alors une image, dite image résultat 14, à partir des images de départ 3a, 3b ayant subi l'étape de seuillage adaptatif, en affectant à chaque pixel de l'image résultat 14 un niveau de contraste normal choisi parmi les trois niveaux de contraste normaux blanc, noir, gris et déterminé, selon une règle logique de comparaison prédéterminée en fonction de la nature de la comparaison à effectuer, et selon les niveaux de contraste normaux des pixels correspondants de même emplacement des images de départ 3a, 3b déterminés à l'issue du traitement de seuillage adaptatif.

Par exemple, avantageusement et selon l'invention, on utilise une règle logique de comparaison choisie parmi les règles logiques de comparaison suivantes :

- intersection étendue AND+ : on affecte à chaque pixel de l'image résultat le niveau de contraste normal :

  . noir si les deux pixels correspondant des images de départ sont noirs,
  . blanc si les deux pixels correspondant des images de départ sont blancs,
  . gris dans les autres cas,

- OU EXCLUSIF étendu XOR+ : on affecte à chaque pixel de l'image résultat le niveau de contraste normal :

  . gris si les deux pixels correspondant des images de départ ont le même niveau de contraste normal,
  . blanc si les deux pixels correspondant des images de départ sont blanc et gris ; ou blanc et noir ; ou gris et noir,
  . noir si les deux pixels correspondant des images de départ sont noir et gris : ou noir et blanc ; ou gris et blanc.

Une intersection étendue AND+ permet de visualiser sur l'image résultat 14 les états électriques communs entre les deux images de départ 3a, 3b, c'est-à-dire les lignes équipotentielles communes aux images de départ 2a, 2b. Une comparaison par OU EXCLUSIF étendu XOR+ permet de visualiser les différences d'états électriques entre les deux images 3a, 3b, c'est-à-dire les lignes équipotentielles des images de départ 2a, 2b, de même forme, de même emplacement, mais de potentiels différents, notamment de potentiels opposés.

Avantageusement et selon l'invention, on soumet l'image résultat 14 à un traitement de réduction comprenant un filtrage médian consistant à affecter à chaque pixel la valeur médiane des niveaux de contraste normaux de l'ensemble de pixels comprenant ce pixel et les pixels qui l'entourent, puis un traitement d'érosion et de dilatation pour les niveaux de contraste normaux blanc et noir.

L'invention permet ainsi d'analyser et de comparer des images de circuit intégré de façon simple et rapide par voie numérique. Elle est applicable notamment pour la localisation de défauts sur des circuits intégrés logiques défaillants. On peut ainsi visualiser sur l'image résultat 14 une porte logique défaillante et/ou une ligne équipotentielle d'entrée de porte logique défaillante et/ou une ligne équipotentielle de sortie de porte logique défaillante.

En outre, il est à noter que les deux images de départ 2a, 2b, peuvent être représentatives d'une même zone d'une même puce d'un circuit intégré, ou, au contraire, être représentatives d'une même zone d'une puce de deux circuits intégrés différents, par exemple un circuit intégré défaillant, et le circuit de référence qui lui correspond non défaillant. En effet, à l'issue de l'étape de seuillage adaptatif, les images étant simplifiées peuvent être réalignées l'une par rapport à l'autre avant de former l'image résultat 14 et d'effectuer la règle logique de comparaison adéquate. Ce réalignement peut même être effectué par traitement informatique puisque la forme générale des objets de l'image est définie sans ambiguïté à l'issue de l'étape de seuillage adaptatif.

Le procédé selon l'invention peut être réalisé par programmation des fonctions sus-décrites sur tout système informatique approprié, par exemple sur le système d'imagerie IDS 5000 HX lui-même.

L'invention peut faire l'objet de nombreuses autres applications et variantes de réalisation par rapport à celles décrites ci-dessus et représentées sur les figures.

## Revendications

1. Procédé de comparaison de deux images, dites images de départ (2a, 2b), enregistrées, formées de pixels, de même format rectangulaire, représentant sous forme contrastée monochrome, avec E+1 niveaux de contraste possibles, des lignes équipotentielles d'au moins une puce de circuit intégré, **ca-**

**ractérisé en ce que** :

- on soumet chaque image de départ (2a, 2b) à un traitement de seuillage adaptatif à trois niveaux de contraste distincts, dits niveaux de contraste normaux, blanc, noir et gris, de façon à affecter à chaque pixel de l'image l'un de ces trois niveaux de contraste normaux,
- on forme ensuite une image, dite image résultat (14), à partir des images de départ (3a, 3b) ainsi traitées, en affectant à chaque pixel de l'image résultat (14) un niveau de contraste normal choisi parmi les trois niveaux de contraste normaux blanc, noir, gris, et déterminé selon une règle logique de comparaison prédéterminée en fonction de la nature de la comparaison à effectuer, et selon les niveaux de contraste normaux affectés aux pixels correspondant de même emplacement des images de départ (3a, 3b) à l'issue du traitement de seuillage adaptatif.

2. Procédé selon la revendication 1, **caractérisé en ce que** pour réaliser le traitement de seuillage adaptatif d'une image de départ comprenant b colonnes de pixels et c lignes de pixels :

- on définit à partir de l'image de départ (2a, 2b) une pluralité de rectangles Ri, j formés de blocs rectangulaires de d lignes de pixels et e colonnes de pixels, extraits de l'image de départ, d<c et e<b, les rectangles Ri,j étant définis pour représenter l'image de départ (2a, 2b) en lignes i de rectangles et en colonnes j de rectangles,
- on calcule pour chaque rectangle Ri,j, la valeur du niveau de contraste minimum NGmin, la valeur du niveau de contraste maximum NGmax, la valeur du niveau de contraste moyen NGmoy, la valeur de l'écart-type des niveaux de contraste ETNG, des différents pixels du rectangle Rij,
- on calcule le nombre de niveaux de contraste normaux devant être affectés à chaque rectangle Ri,j,
- on détermine la valeur de chaque niveau de contraste normal de chaque rectangle Ri, j,
- on établit, pour chaque rectangle Ri,j, une loi de transformation du niveau de contraste réel de chaque pixel de l'image de départ en un niveau de contraste normal affecté à ce pixel.

3. Procédé selon la revendication 2, **caractérisé en ce qu'**on définit les rectangles Rij de façon que :

. toute paire de rectangles Ri, j ; Ri,j+1 qui se jouxtent sur une même ligne de rectangles se chevauchent sur la moitié de leur largeur, c'est-à-dire présentent un nombre de colonnes en commun de l'ordre de e/2,

. toute paire de rectangles Ri,j ; Ri+1,j qui se jouxtent sur une même colonne de rectangles se chevauchent sur la moitié de leur largeur, c'est-à-dire présentent un nombre de lignes en commun de l'ordre de d/2.

4. Procédé selon l'une des revendications 2 ou 3, **caractérisé en ce qu'**on choisit d et e de telle sorte que si la taille minimum de chaque objet représenté par l'image de départ est un rectangle de g pixels de longueur et f pixels de largeur, f≤g, on ait : 10≤ e ≤10 f et 10≤ d ≤10 g.

5. Procédé selon la revendication 4, **caractérisé en ce qu'**on choisit d et e compris entre 20 et 60, notamment de l'ordre de 40 pour f et g compris entre 5 et 15, notamment de l'ordre de 10.

6. Procédé selon l'une des revendications 2 à 5, **caractérisé en ce qu'**on choisit d et e, de telle sorte que d/e=c/b.

7. Procédé selon l'une des revendications 2 à 6, **caractérisé en ce que** pour calculer le nombre de niveaux de contraste normaux NNG dans chaque rectangle Ri,j :

   - on calcule le nombre de pics principaux NP de la courbe histogramme des niveaux de contraste réels du rectangle Ri,j, chaque pic correspondant à un maximum de la courbe histogramme,
   - on définit les conditions suivantes :

      . première condition : la courbe histogramme présente au moins trois pics,
      . deuxième condition : NGmoy≥S1 et (NGmax-NGmin)/NGmoy≥S2,
      . troisième condition : NGmax-NGmin≥S3 et ETNG≥S4,
      . quatrième condition : la courbe histogramme présente au moins deux pics,
      . cinquième condition : NGmax-NGmin≥S5 et ETNG≥S6,
         où S1, S2, S3, S4, S5 et S6 sont des valeurs seuil prédéterminées selon le type de circuit intégré représenté par les images de départ et les caractéristiques de l'installation d'imagerie utilisée pour réaliser ces images de départ,
      . sixième condition : la première condition et l'une au moins de la deuxième condition ou de la troisième condition sont satisfaites,
      . septième condition : la quatrième condition et la cinquième conditions sont satisfaites,

   - on examine si la sixième condition est satisfaisante, et, si tel est le cas, on fixe et on enregistre le nombre de niveaux de contraste normaux NNG égal à trois ; si tel n'est pas le cas, on examine si la septième condition est satisfaite et, si tel est le cas, on fixe et on enregistre le nombre de niveaux de contraste normaux NNG égal à deux ; si tel n'est pas le cas, aucune de la sixième et de la septième condition n'étant satisfaite, on fixe et on enregistre le nombre de niveaux de contraste normaux NNG égal à un.

8. Procédé selon la revendication 7, **caractérisé en ce que** les circuits intégrés étant de type CMOS avec des règles de dessins comprises entre 0,7μ et 1,5μ, on choisit : S1 de l'ordre de 100 ; S2 de l'ordre de 1,3 ; S3 de l'ordre de 160 ; S4 de l'ordre de 47 ; S5 de l'ordre de 130 ; S6 de l'ordre de 60.

9. Procédé selon l'une des revendications 7 et 8, **caractérisé en ce que** lorsque le nombre de niveaux de contraste normaux NNG d'au moins un rectangle Ri,j de l'image de départ est égal à trois, pour affecter un niveau de contraste normal NCN à chaque pixel dont le niveau de contraste réel est NCR:

   - on sépare les pics de la courbe histogramme du rectangle Ri,j par des frontières verticales passant par les points de minimum entre les pics,
   - on calcule par intégration l'aire de chaque pic de la courbe histogramme du rectangle Ri,j, on sélectionne les trois grands pics présentant des aires de plus grandes valeurs, on choisit parmi ces trois grands pics, un pic, dit pic central disposé entre les deux autres, et qui est délimité par une frontière inférieure FI et une frontière supérieure FS sur l'échelle des niveaux de contraste,
   - on affecte le niveau de contraste normal NCN égal à gris pour tout pixel dont le niveau de contraste réel NCR est compris entre la frontière inférieure FI et la frontière supérieure FS,
   - on affecte le niveau de contraste normal NCN égal à noir pour tout pixel dont le niveau de contraste réel NCR est inférieur à la frontière inférieure FI,
   - on affecte le niveau de contraste normal NCN égal à blanc pour tout pixel dont le niveau de contraste réel NCR est supérieur à la frontière supérieure FS.

10. Procédé selon la revendication 9, **caractérisé en ce que** pour chaque rectangle Ri',j' dont le nombre de niveaux de contraste normaux NNG est inférieur ou égal à 2, on détermine la valeur de ce(ces) niveau(x) de contraste normal(aux) NNG à partir d'un rectangle Ri,j comprenant trois niveaux de contraste normaux que l'on a préalablement affectés, en affectant de proche en proche les niveaux de contraste normaux des pixels communs au(x) rectangle(s) qui se chevauchent entre les rectangles Ri,j et Ri',j'.

11. Procédé selon l'une des revendications 7 et 8, **caractérisé en ce que** lorsqu'aucun rectangle Ri, j n'a un nombre de niveaux de contraste normaux NNG égal à trois, mais qu'au moins un rectangle Ri,j a un nombre de niveaux de contraste normal égal à deux, à savoir un niveau de contraste normal inférieur et un niveau de contraste normal supérieur, on affecte le niveau de contraste normal gris à l'un des niveaux de contraste normaux d'au moins un rectangle, dit premier rectangle, ayant deux niveaux de contraste normaux, et on affecte les niveaux de contraste normaux des autres rectangles de proche en proche à partir du premier rectangle.

12. Procédé selon la revendication 11, **caractérisé en ce qu'**on affecte le niveau de contraste normal gris du premier rectangle par examen visuel et saisie manuelle.

13. Procédé selon l'une des revendications 7 et 8, **caractérisé en ce que** lorsqu'aucun rectangle Ri,j n'a un nombre de niveaux de contraste normaux NNG égal à trois, on traite les rectangles Ri,j les uns après les autres, de proche en proche, en étapes successives, en comparant lors de chaque étape une zone, dite zone de départ, formée d'au moins un rectangle Ri,j ayant subi préalablement une telle étape, et un rectangle Ri,j présentant une zone de chevauchement commune avec la zone de départ.

14. Procédé selon l'une des revendications 7 et 8, **caractérisé en ce que** lorsque le nombre de niveaux de contraste normaux de tous les rectangles Ri,j est égal à 1, on affecte le niveau de contraste normal gris à tous les pixels de l'image.

15. Procédé selon l'une des revendications 2 à 14, **caractérisé en ce qu'**après avoir affecté les niveau de contraste normaux à tous les pixels d'un rectangle Ri,j, on soumet ce rectangle Ri,j à un traitement de réduction comprenant un filtrage médian lors duquel on affecte à chaque pixel la valeur médiane des niveaux de contraste normaux de l'ensemble de pixels comprenant ce pixel et les pixels qui l'entourent.

16. Procédé selon l'une des revendications 2 à 15, **caractérisé en ce qu'**on reconstruit l'image de départ (3a, 3b) en réassemblant les rectangles Ri,j, les uns après les autres en étapes de réassemblage successives à partir d'une image grise de même format que l'image de départ (3a, 3b), et en effectuant, pixel par pixel, une règle logique OU étendu OR+ entre l'image de l'étape précédente et le rectangle Ri,j à réassembler, en affectant à chaque pixel de l'image de départ (3a, 3b) à reconstruire le niveau de contraste normal :

- blanc si les pixels de l'image de l'étape de réassemblage précédente et du rectangle Ri,j sont, respectivement, blanc et gris ; ou blanc et blanc ;
- noir si les pixels de l'image de l'étape de réassemblage précédente et du rectangle Ri,j sont, respectivement, noir et gris ; ou noir et noir ;
- gris dans les autres cas.

17. Procédé selon l'une des revendications 1 à 16, **caractérisé en ce qu'**on utilise une règle logique de comparaison choisie parmi les règles logiques de comparaison suivantes :

- intersection étendue AND+ : on affecte à chaque pixel de l'image résultat le niveau de contraste normal :

  . noir si les deux pixels correspondant des images de départ sont noirs,
  . blanc si les deux pixels correspondant des images de départ sont blancs,
  . gris dans les autres cas,

- OU EXCLUSIF étendu XOR+ : on affecte à chaque pixel de l'image résultat le niveau de contraste normal :

  . gris si les deux pixels correspondant des images de départ ont le même niveau de contraste normal,
  . blanc si les deux pixels correspondant des images de départ sont blanc et gris ; ou blanc et noir ; ou gris et noir,
  . noir si les deux pixels correspondant des images de départ sont noir et gris : ou noir et blanc ; ou gris et blanc.

18. Procédé selon l'une des revendications 1 à 17, **caractérisé en ce qu'**au moins l'une des images de départ résulte d'une étape de différence effectuée préalablement entre deux images, dites images initiales, représentant une portion de surface d'une puce de circuit intégré, et lors de laquelle on calcule le niveau de contraste réel NCR de chaque pixel de l'image de départ à partir des niveaux de contraste réels NCRA et NCRB des pixels correspondant de même emplacement des images initiales selon la formule :

$$NCR = (NCRA - NCRB)/2 + INT(E/2)$$

**19.** Procédé selon l'une des revendications 1 à 18, **caractérisé en ce qu'**avant d'utiliser une image de départ dans une étape de comparaison d'images, on réalise préalablement une intégration de cette image de départ sur plusieurs clichés identiques correspondant à cette image de départ, et un filtrage médian en affectant à chaque pixel la valeur médiane de l'ensemble de pixels formé de ce pixel et des pixels qui l'entourent, de façon à supprimer les pics dus au bruit.

**20.** Procédé selon les revendications 18 et 19, **caractérisé en ce qu'**on réalise l'intégration et le filtrage médian sur les images initiales dont on fait ensuite la différence pour obtenir une image de départ.

**21.** Procédé selon l'une des revendications 1 à 20, **caractérisé en ce qu'**on soumet l'image résultat (14) à un traitement de réduction comprenant un filtrage médian consistant à affecter à chaque pixel la valeur médiane des niveaux de contraste normaux de l'ensemble de pixels comprenant ce pixel et les pixels qui l'entourent, puis un traitement d'érosion et de dilatation pour les niveaux de contraste normaux blanc et noir.

**Patentansprüche**

**1.** Verfahren zum Vergleichen von zwei aus Pixeln gebildeten gespeicherten Bildern, Ausgangsbilder (2a, 2b) genannt, mit demselben rechteckigen Format, die in einer kontrastierten Monochrom-Form mit E+1 möglichen Kontrastniveaus equipotentielle Linien von wenigstens einem integrierten Schaltungschip aufweisen, **dadurch gekennzeichnet, dass** es die folgenden Schritte umfasst:

- Unterziehen jedes Ausgangsbildes (2a, 2b) einer adaptiven Schwellwertidentifizierung auf drei getrennten Kontrastniveaus, Normalkontrastniveaus weiß, schwarz und grau genannt, um auf jedes Pixel des Bildes eines der drei Normalkontrastniveaus anzuwenden,
- anschließendes Bilden eines Bildes, Ergebnisbild (14) genannt, auf der Basis der so behandelten Ausgangsbilder (3a, 3b), indem auf jedes Pixel des Ergebnisbildes (14) ein Normalkontrastniveau angewendet wird, das ausgewählt wurde aus den drei Normalkontrastniveaus weiß, schwarz, grau, und bestimmt gemäß einer logischen Vergleichsregel, die in Abhängigkeit von der Natur des durchzuführenden Vergleichs bestimmt wird, und gemäß den auf die Pixel angewendeten Normalkontrastniveaus entsprechend derselben Platzierung von Ausgangsbildern (3a, 3b) am Ausgang der adaptiven Schwellwertidentifizierung.

**2.** Verfahren nach Anspruch 1, **dadurch gekennzeichnet, dass** zum Durchführen der adaptiven Schwellwertidentifizierung eines Ausgangsbildes mit b Pixelspalten und c Pixelreihen die folgenden Schritte durchgeführt werden:

- Definieren, auf der Basis des Ausgangsbildes (2a, 2b), einer Mehrzahl von Rechtecken Ri,j, die von rechteckigen Blöcken von d Pixelreihen und e Pixelspalten gebildet werden, Extrahieren des Ausgangsbildes d<c und e<b, wobei die Rechtecke Ri,j definiert werden, um das Ausgangsbild (2a, 2b) in Reihen i von Rechtecken und in Spalten j von Rechtecken darzustellen,
- Errechnen, für jedes Rechteck Ri,j, den Wert des Mindestkontrastniveaus NGmin, den Wert des Höchstkontrastniveaus NGmax, den Wert des mittleren Kontrastniveaus NGmoy, den Abstandstypwert von ETNG-Kontrastniveaus verschiedener Pixel des Rechtecks Rij,
- Errechnen der Zahl der Normalkontrastniveaus, die auf jedes Rechteck Ri,j angewendet werden müssen,
- Bestimmen des Wertes jedes Normalkontrastniveaus jedes Rechtecks Ri,j,
- Erstellen, für jedes Rechteck Ri,j, eines Gesetzes zur Umformung des reellen Kontrastniveaus jedes Pixels des Ausgangsbildes in einem auf dieses Pixel angewendeten Normalkontrastniveau.

**3.** Verfahren nach Anspruch 2, **dadurch gekennzeichnet, dass** die Rechtecke Rij so definiert werden, dass:

. jedes Paar Rechtecke Ri,j ; Ri,j+1, die auf derselben Reihe von Rechtecken nebeneinander liegen, einander in der Mitte ihrer Breite überlappen, d.h. zusammen eine Spaltenzahl in der Größenordnung von e/2 bilden,
. jedes Paar Rechtecke Ri,j ; Ri+1,j, die auf derselben Spalte von Rechtecken nebeneinander liegen, einander in der Mitte ihrer Breite überlappen, d.h. zusammen eine Reihenzahl in der Größenordnung von d/2 bilden.

**4.** Verfahren nach Anspruch 2 oder 3, **dadurch gekennzeichnet, dass** d und e so gewählt werden, dass, wenn die Mindestgröße jedes durch das Ausgangsbild dargestellten Objekts ein Rechteck von g Längenpixeln und f Breitenpixeln ist, f≦g, sich Folgendes ergibt: $10 \leq e \leq 10\,f$ und $10 \leq d \leq 10\,g$.

**5.** Verfahren nach Anspruch 4, **dadurch gekennzeichnet, dass** d und e zwischen 20 und 60, insbesondere in der Größenordnung von 40, für f und g zwischen 5 und 15, insbesondere in der Größenordnung von 10, gewählt werden.

6. Verfahren nach einem der Ansprüche 2 bis 5, **dadurch gekennzeichnet, dass** d und e so gewählt werden, dass d/e=c/b ist.

7. Verfahren nach einem der Ansprüche 2 bis 6, **dadurch gekennzeichnet, dass** für die Berechnung der Zahl der Normalkontrastniveaus NNG in jedem Rechteck Ri,j:

   - die Zahl der NP-Hauptpixel der Histogrammkurve von reellen Kontrastniveaus des Rechtecks Ri,j, errechnet wird,

   wobei jedes Pixel einem Maximum der Histogrammkurve entspricht,

   - die folgenden Bedingungen definiert werden:

     . erste Bedingung: die Histogrammkurve stellt wenigstens drei Pixel dar,
     . zweite Bedingung: NGmoy≥S1 und (NGmax-NGmin)/NGmoy≥S2,
     . dritte Bedingung: NGmax-NGmin≥S3 und ETNG≥S4,
     . vierte Bedingung: die Histogrammkurve stellt wenigstens zwei Pixel dar,
     . fünfte Bedingung: NGmax-NGmin≥S5 und ETNG≥S6,
         wobei S1, S2, S3, S4, S5 und S6 Schwellenwerte sind, die gemäß dem integrierten Schaltungschip vorbestimmt sind, der durch die Ausgangsbilder und die Charakteristiken der Abbildungsanlage repräsentiert wird, die für die Realisierung dieser Ausgangsbilder verwendet wird,
     . sechste Bedingung: die erste Bedingung und die zweite Bedingung und/oder die dritte Bedingung erfüllt sind,
     . siebte Bedingung: die vierte Bedingung und die fünfte Bedingung erfüllt sind,

   - untersucht wird, ob die sechste Bedingung erfüllt ist, und wenn dies der Fall ist, die Zahl der Normalkontrastniveaus NNG mit drei festgelegt und gespeichert wird; und wenn dies nicht der Fall ist, untersucht wird, ob die siebte Bedingung erfüllt ist, und wenn dies der Fall ist, die Zahl der Normalkontrastniveaus NNG auf zwei festgelegt und gespeichert wird; und wenn dies nicht der Fall ist, weder die sechste noch die siebte Bedingung erfüllt ist, die Zahl der Normalkontrastniveaus NNG auf eins festgelegt und gespeichert wird.

8. Verfahren nach Anspruch 7, **dadurch gekennzeichnet, dass** bei.integrierten Schaltungen vom CMOS-Typ mit Zeichnungsregeln zwischen 0,7μ und 1,5μ Folgendes gewählt wird: S1 in der Größenordnung von 100; S2 in der Größenordnung von 1,3; S3 in der Größenordnung von 160; S4 in der Größenordnung von 47; S5 in der Größenordnung von 130; S6 in der Größenordnung von 60.

9. Verfahren nach einem der Ansprüche 7 und 8, **dadurch gekennzeichnet, dass**, wenn die-Zahl der Normalkontrastniveaus NNG von wenigstens einem Rechteck Ri,j des Ausgangsbildes drei .ist, zum Anwenden eines NCN-Normalkontrastniveaus auf jedes Pixel, dessen reelles NCR-Kontrastniveau ist:

   - die Spitzen der Histogrammkurve des Rechtecks Ri,j durch die vertikalen Grenzen getrennt werden, die durch die Minimumpunkte zwischen diesen Spitzen verlaufen,
   - durch Integration die Fläche jeder Spitze der Histogrammkurve des Rechtecks Ri,j errechnet wird, die drei großen Spitzen gewählt werden, die Flächen mit den größten Werten darstellen, aus den drei großen Spitzen eine Spitze ausgewählt wird, zentrale Spitze genannt, die zwischen den beiden anderen angeordnet ist, und die durch eine untere Grenze FI und eine obere Grenze FS auf der Kontrastniveauskala begrenzt wird,
   - das NCN-Normalkontrastniveau grau für jedes Pixel angewendet wird, dessen reelles NCR-Kontrastniveau zwischen der Untergrenze FI und der Obergrenze FS liegt,
   - das NCN-Normalkontrastniveau schwarz für jedes Pixel angewendet wird, dessen reelles NCR-Kontrastniveau unter der Untergrenze FI liegt,
   - das NCN-Normalkontrastniveau weiß für jedes Pixel angewendet wird, dessen reelles Kontrastniveau NCR über der Obergrenze FS liegt.

10. Verfahren nach Anspruch 9, **dadurch gekennzeichnet, dass** für jedes Rechteck Ri',j', dessen Zahl von NNG-Normalkontrastniveaus kleiner oder gleich 2 ist, der Wert dieses/dieser NNG-Normalkontrastniveaus auf der Basis eines Rechtecks Ri,j bestimmt wird, das drei Normalkontrastniveaus umfasst, die zuvor angewendet wurden, indem näherungsweise die Normalkontrastniveaus von Pixeln angewendet werden, die dem/den Rechteck(en) gemeinsam sind, die einander zwischen den Rechtecken Ri,j und Ri',j' überlappen.

11. Verfahren nach einem der Ansprüche 7 und 8, **dadurch gekennzeichnet, dass**, wenn kein Rechteck Ri,j eine Zahl von NNG-Normalkontrastniveaus von drei hat, aber wenigstens ein Rechteck Ri,j eine Zahl von Normalkontrastniveaus von zwei hat, nämlich ein unteres Normalkontrastniveau und ein oberes Normalkontrastniveau, das Normalkontrastniveau grau auf eines der Normalkontrastniveaus von wenigstens einem Rechteck angewendet wird, erstes Rechteck genannt, das zwei Normalkontrastniveaus hat, und die Normalkontrastniveaus anderer Rechtecke näherungsweise auf der Basis des ersten Rechtecks angewendet werden.

12. Verfahren nach Anspruch 11, **dadurch gekennzeichnet, dass** das Normalkontrastniveau grau des ersten Rechtecks durch visuelle Überprüfung und manuelles Erfassen angewendet wird.

13. Verfahren nach einem der Ansprüche 7 und 8, **dadurch gekennzeichnet, dass**, wenn kein Rechteck Ri,j eine Zahl von NNG-Normalkontrastniveaus von drei hat, die Rechtecke Ri,j nacheinander näherungsweise in aufeinander folgenden Stufen behandelt werden, indem in jeder Stufe eine Zone, Ausgangszone genannt, die von wenigstens einem Rechteck Ri,j gebildet wird, das zuvor einer solchen Stufe unterzogen wurde, mit einem Rechteck Ri,j verglichen wird, das eine Überlappungszone darstellt, die mit der Ausgangszone gemein ist.

14. Verfahren nach einem der Ansprüche 7 und 8, **dadurch gekennzeichnet, dass**, wenn die Zahl der Normalkontrastniveaus aller Rechtecke Ri,j gleich eins ist, das graue Normalkontrastniveau auf alle Pixel des Bildes angewendet wird.

15. Verfahren nach einem der Ansprüche 2 bis 14, **dadurch gekennzeichnet, dass** nach dem Anwenden der Normalkontrastniveaus auf alle Pixel eines Rechteckes Ri,j dieses Rechteck Ri,j einer Reduktionsbehandlung unterzogen wird, umfassend eine Medianfilterung, bei der auf jedes Pixel der Medianwert der Normalkontrastniveaus der Gesamtheit der Pixel angewendet wird, die dieses Pixel und die dieses umgebenden Pixel umfasst.

16. Verfahren nach einem der Ansprüche 2 bis 15, **dadurch gekennzeichnet, dass** das Ausgangsbild (3a., 3b) rekonstruiert wird, indem die Rechtecke Ri,j nacheinander in aufeinander folgenden Wiederzusammenfügungsstufen auf der Basis eines grauen Bildes desselben Formates wie das Ausgangsbild (3a, 3b) wieder zusammengefügt wird, und indem ein Logikglied OR+ zwischen dem Bild der vorherigen Stufe und dem wieder zusammenzufügenden Rechteck Ri,j pixelweise angewendet wird, indem auf jedes Pixel des zu rekonstruierenden Ausgangsbildes (3a, 3b) das folgende Normalkontrastniveaus angewendet wird:

- weiß, wenn die Pixel des Bildes der vorherigen Wiederzusammenfügungsstufe und des Rechtecks Ri,j jeweils weiß-grau oder weiß-weiß sind;

- schwarz, wenn die Pixel des Bildes der vorherigen Wiederzusammenfügungsstufe und des Rechtecks Ri,j jeweils schwarz-grau oder schwarz-schwarz sind;

- grau in allen anderen Fällen.

17. Verfahren nach einem der Ansprüche 1 bis 16, **dadurch gekennzeichnet, dass** eine logische Verknüpfung angewendet wird, ausgewählt aus den folgenden logischen Verknüpfungen:

- erweiterter Schnittpunkt AND+: es wird auf jedes Pixel des Ergebnisbildes das folgende Normalkontrastniveau angewendet:

    . schwarz, wenn die beiden Ausgangsbildern entsprechenden Pixel schwarz sind,
    . weiß, wenn die beiden Ausgangsbildern entsprechenden Pixel weiß sind,
    . grau in allen anderen Fällen,

- erweitertes EXKLUSIV-ODER (XOR+): auf jedes Pixel des Ergebnisbildes wird das folgende Normalkontrastniveau angewendet:

    . grau, wenn die beiden Ausgangsbildern entsprechenden Pixel dasselbe Normalkontrastniveau haben,
    . weiß, wenn die beiden Ausgangsbildern entsprechenden Pixel weiß-grau, weiß-schwarz oder grauschwarz sind,
    . schwarz, wenn die beiden Ausgangsbildern entsprechenden Pixel schwarz-grau oder schwarz-weiß oder grau-weiß sind.

18. Verfahren nach einem der Ansprüche 1 bis 17, **dadurch gekennzeichnet, dass** wenigstens eines der Ausgangsbilder aus einer Differentialstufe resultiert, die zuvor zwischen zwei Bildern durchgeführt wurde, Anfangsbilder genannt, die einen Abschnitt der Oberfläche eines integrierten Schaltungschips repräsentieren, und bei der das reelle NCR-Kontrastniveau jedes Pixels des Ausgangsbildes auf der Basis der reellen NCRA- und NCRB-Kontrastniveaus von Pixeln errechnet wird, die derselben Position von Anfangsbildern gemäß der folgenden Formel entsprechen:

$$NCR = (NCRA - NCRB)/2 + INT(E/2)$$

19. Verfahren nach einem der Ansprüche 1 bis 18, **dadurch gekennzeichnet**, dass vor dem Verwenden eines Ausgangsbildes in einer Bildervergleichsstufe zuvor eine Integration dieses Ausgangsbildes auf mehreren identischen Klischees, die diesem Ausgangsbild entsprechen, und eine Medianfilterung erfolgt, indem auf jedes Pixel der Medianwert der Gesamtheit der Pixel angewendet wird, die von diesem Pixel und den dieses umgebenden Pixel gebildet wird, um von Rauschen verursachte Spitzen zu unterdrücken.

20. Verfahren nach Anspruch 18 und 19, **dadurch gekennzeichnet, dass** die Integration und Medianfilterung auf die Anfangsbilder angewendet wird, von denen dann die Differenz erzeugt wird, um ein Ausgangsbild zu erhalten.

21. Verfahren nach einem der Ansprüche 1 bis 20, **dadurch gekennzeichnet, dass** das Ergebnisbild (14) einer Reduktionsbehandlung unterzogen wird, umfassend eine Medianfilterung, die daraus besteht, auf jedes Pixel den Medianwert von Normalkontrastniveaus der Gesamtheit der Pixel anzuwenden, die dieses Pixel und die es umgebenden Pixel umfassen, dann eine Erosionsbehandlung und eine Dilatationsbehandlung für die Normalkontrastniveaus schwarz und weiß.

**Claims**

1. A method for comparing two recorded pixel images of the same rectangular format, called source images (2a, 2b), representing in monochrome contrasted form, with E+1 possible contrast levels, equipotential lines of at least an integrated circuit chip, **characterized in that**:

   - each source image (2a, 2b) is subjected to an adaptive thresholding processing with three distinct contrast levels, white, black and gray, called normal contrast levels, so as to assign to each pixel of the image one of these three normal contrast levels,
   - an image, called the result image (14), is then formed from the thus processed source images (3a, 3b) by assigning to each pixel of the result image (14) a normal contrast level selected from the three normal contrast levels of white, black and gray and determined in accordance with a predetermined logical rule of comparison, according to the nature of the comparison to be made, and in accordance with the normal contrast levels assigned to the corresponding pixels of the same location of the source images (3a, 3b) on completion of the adaptive thresholding processing.

2. A method as claimed in claim 1, **characterized in that**, the adaptive thresholding processing of a source image comprising b columns of pixels and c rows of pixels is effected by:

   - defining, from the source image (2a, 2b), a plurality of rectangles Ri,j formed of rectangular blocks of d rows of pixels and e columns of pixels, extracted from the source image, d<c and e<b, the rectangles Ri,j being defined to represent the source image (2a, 2b) in rows i of rectangles and columns j of rectangles,
   - calculating, for each rectangle Ri,j, the value of the minimum contrast level NGmin, the value of the maximum contrast level NGmax, the value of the mean contrast level NGmoy and the value of the standard deviation of the contrast levels ETNG of the different pixels of the rectangle Ri,j,
   - calculating the number of normal contrast levels having to be assigned to each rectangle Ri,j,
   - determining the value of each normal contrast level of each rectangle Ri,j,
   - establishing, for each rectangle Ri,j, a law for converting the actual contrast level of each pixel of the source image into a normal contrast level assigned to that pixel.

3. A method as claimed in claim 2, **characterized in that** the rectangles Ri,j are defined so that:

   . each pair of rectangles Ri,j; Ri,j+1 which adjoin on the same row of rectangles overlap over half of their width, i.e., have a number of columns in common, of the order of e/2,
   . each pair of rectangles Ri,j; Ri+1,j which adjoin on the same column of rectangles overlap over half of their width, i.e., have a number of rows in common, of the order of d/2.

4. A method as claimed in either of claims 2 or 3, **characterized in that** d and e are selected so that if the minimum size of each object represented by the source image is a rectangle of g pixels in length and f pixels in width, f≤g, then:

$$10 \le e \le 10 \, f \text{ and } 10 \le d \le g.$$

5. A method as claimed in claim 4, **characterized in that** d and e are selected to be between 20 and 60, in particular, of the order of 40 for f and g between 5 and 15, in particular, of the order of 10.

6. A method as claimed in any one of claims 2 to 5, **characterized in that** d and e are selected so that d/e=c/b.

7. A method as claimed in any one of claims 2 to 6, **characterized in that** the number of normal contrast levels NNG in each rectangle Ri,j is calculated by:

**17**

- calculating the number of main peaks NP of the histogram curve of the actual contrast levels of the rectangle Ri,j, each peak corresponding to a maximum of the histogram curve,
- defining the following conditions:

    . first condition: the histogram curve has at least three peaks,
    . second condition: NGmoy≥S1 and (NGmax-NGmin)/NGmoy≥S2,
    . third condition: NGmax-NGmin≥S3 and ETNG≥S4,
    . fourth condition: the histogram curve has at least two peaks,
    . fifth condition: NGmax-NGmin≥S5 and ETNG≥S6,
        wherein S1, S2, S3, S4, S5 and S6 are threshold values predetermined according to the type of integrated circuit represented by the source images and the characteristics of the image processing installation used for producing these source images,
    . sixth condition: the first condition and at least one of the second condition or the third condition are fulfilled,
    . seventh condition: the fourth condition and the fifth condition are fulfilled,

- examining whether the sixth condition is fulfilled and, if such is the case, defining and recording the number of normal contrast levels NNG equal to three; if such is not the case, examining whether the seventh condition is fulfilled and, if such is the case, defining and recording the number of normal contrast levels NNG equal to two; if such is not the case, with neither the sixth nor the seventh condition being fulfilled, defining and recording the number of normal contrast levels NNG equal to one.

8. A method as claimed in claim 7, **characterized in that** for CMOS type integrated circuits with layout gauges of between 0.7 μ and 1.5 μ, S1 is selected to be of the order of 100; S2 of the order of 1.3; S3 of the order of 160; S4 of the order of 47, S5 of the order of 130; S6 of the order of 60.

9. A method as claimed in either of claims 7 or 8, **characterized in that** when the number of normal contrast levels NNG of at least one rectangle Ri,j of the source image is equal to three, a normal contrast level NCN is assigned to each pixel whose actual contrast level is NCR by:

- separating the peaks of the histogram curve of the rectangle Ri,j by vertical boundaries passing through the minimum points between the peaks,
- calculating by integration the area of each peak of the histogram curve of the rectangle Ri,j, selecting the three large peaks which have larger values, selecting from these three large peaks one peak, called the central peak, which is located between the two others and is delimited by a lower boundary FI and an upper boundary FS on the scale of contrast levels,
- assigning the normal contrast level NCN equal to gray for any pixel whose actual contrast level NCR is included between the lower boundary FI and the upper boundary FS,
- assigning the normal contrast level NCN equal to black for any pixel whose actual contrast level NCR is below the lower boundary FI,
- assigning the normal contrast level NCN equal to white for any pixel whose actual contrast level NCR is above the upper boundary FS.

10. A method as claimed in claim 9, **characterized in that** for each rectangle Ri',j' whose number of normal contrast levels NNG is less than or equal to 2, the value of this (these) normal contrast level(s) NNG is determined from a rectangle Ri,j comprising three previously assigned normal contrast levels, by assigning step-by-step the normal contrast levels of the pixels common to the rectangle(s) which overlap between the rectangles Ri,j and Ri',j'.

11. A method as claimed in either of claims 7 or 8, **characterized in that** when no rectangle Ri,j has a number of normal contrast levels NNG equal to three, but at least one rectangle Ri,j has a number of normal contrast levels equal to two, namely, a lower normal contrast level and an upper normal contrast level, the normal contrast level gray is assigned to one of the normal contrast levels of at least one rectangle, called the first rectangle, having two normal contrast levels, and the normal contrast levels of the other rectangles are assigned step-by-step from the first rectangle.

12. A method as claimed in claim 11, **characterized in that** the normal contrast level gray of the first rectangle is assigned by visual examination and manual capture.

13. A method as claimed in either of claims 7 or 8, **characterized in that**, when no rectangle Ri,j has a number of normal contrast levels NNG equal to three, the rectangles Ri,j are processed one after the other, step-by-step, in successive stages, by comparing in each stage a zone, called the source zone, formed of at least one rectangle Ri,j having previously undergone such a stage, and a rectangle Ri,j having an overlap zone in common with the source zone.

**14.** A method as claimed in either of claims 7 or 8, **characterized in that**, when the number of normal contrast levels of all the rectangles Ri,j is equal to 1, the normal contrast level gray is assigned to all the pixels of the image.

**15.** A method as claimed in any one of claims 2 to 14, **characterized in that**, when the normal contrast levels have been assigned to all the pixels of a rectangle Ri,j, this rectangle Ri,j is subjected to a reduction processing, comprising a median filtering in the course of which each pixel is assigned the median value of the normal contrast levels of the set of pixels comprising this pixel and the pixels surrounding it.

**16.** A method as claimed in any one of claims 2 to 15, **characterized in that** the source image (3a, 3b) is reconstructed by reassembling the rectangles Ri,j, one after the other, in successive reassembly stages, from a gray image of the same format as the source image (3a, 3b), and by executing, pixel by pixel, an extended OR logical rule OR+ between the image of the preceding stage and the rectangle Ri,j to be reassembled, by assigning to each pixel of the source image (3a, 3b) to be reconstructed the normal contrast level:

- white if the pixels of the image of the preceding reassembly stage and of the rectangle Ri,j are, respectively, white and gray, or white and white;
- black if the pixels of the image of the preceding reassembly stage and of the rectangle Ri,j are, respectively black and gray, or black and black;
- gray in the other cases.

**17.** A method as claimed in any one of claims 1 to 16, **characterized in that** a logical rule of comparison is used which is selected from the following logical rules of comparison:

- extended AND function AND+: each pixel of the result image is assigned the normal contrast level:

    . black if the two corresponding pixels of the source images are black,
    . white if the two corresponding pixels of the source images are white,
    . gray in the other cases,

- extended exclusive-OR function XOR+: each pixel of the result image is assigned the normal contrast level:

    . gray if the two corresponding pixels of the source images have the same normal contrast level,

    . white if the two corresponding pixels of the source images are white and gray, or white and black, or gray and black,
    . black if the two corresponding pixels of the source images are black and gray, or black and white, or gray and white.

**18.** A method as claimed in any one of claims 1 to 17, **characterized in that** at least one of the source images results from a differentiation stage performed previously between two images, called initial images, representing a surface portion of an integrated circuit chip, and in the course of which the actual contrast level NCR of each pixel of the source image is calculated from the actual contrast levels NCRA and NCRB of the corresponding pixels of the same location of the initial images, according to the formula:

$$NCR=(NCRA-NCRB)/2+INT(E/2).$$

**19.** A method as claimed in any one of claims 1 to 18, **characterized in that**, prior to using a source image in an image comparison stage, an integration of this source image is performed on several identical photographs corresponding to this source image, and a median filtering is performed by assigning to each pixel the median value of the set of pixels formed by this pixel and the pixels surrounding it, so as to suppress the peaks due to noise.

**20.** A method as claimed in claims 18 and 19, **characterized in that** integration and median filtering are performed on the initial images which are then differentiated to obtain a source image.

**21.** A method as claimed in any one of claims 1 to 20, **characterized in that** the result image (14) is subjected to a reduction processing comprising a median filtering consisting in assigning to each pixel the median value of the normal contrast levels of the set of pixels comprising this pixel and the pixels surrounding it, followed by an erosion and expansion processing for the normal contrast levels white and black.

Fig 1

Fig 2

2a,2b

Fig 3

Fig 4

Fig 5a

2 / 10 / 30 / 40 / 65 / 85 / 88 / 123 / 205

Fig 5b

0 / 0 / 0 / 0 / 0 / 127 / 255 / 255 / 255